# EUROPEAN PATENT APPLICATION

(11) **EP 4 426 075 A1**
(43) Date of publication of application: **04.09.2024**
(21) Application number: 22886798.2
(22) Date of filing: 18.10.2022
(51) Int. Cl.: H05K 1/03, H01L 23/13

(54) **CERAMIC COPPER CIRCUIT BOARD AND SEMICONDUCTOR DEVICE USING SAME**

(30) Priority: 25.10.2021 JP 2021173832
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: KATO, Hiromasa, Yokohama-shi, Kanagawa 235-0032 (JP); SANO, Takashi, Yokohama-shi, Kanagawa 235-0032 (JP)
(74) Representative: Henkel & Partner mbB
(86) International application number: PCT/JP2022/038771
(87) International publication number: WO 2023/074470

(57) **Abstract**

A ceramic copper circuit board according to one embodiment of the present invention is provided with: a ceramic substrate; and a copper circuit part that is bonded to at least one surface of the ceramic substrate, with a brazing material layer being interposed therebetween. The brazing material layer contains Cu, Ti, and one or two elements that are selected from among Sn and In. The brazing material layer comprises: a bonding part that is provided between the ceramic substrate and the copper circuit part; and a first protrusion part that is provided around the bonding part, and has a titanium content within the range from 70% by mass to 100% by mass. It is preferable that the sum of the titanium content and the nitrogen content in the first protrusion part is within the range from 99% by mass to 100% by mass.

## Description

### [Technical Field]

Embodiments described below are related to a ceramic copper circuit board and a semiconductor device using a ceramic copper circuit board.

### [Background Art]

In recent years, power modules are being used in electric vehicles, electric trains, and the like to control large currents and high voltages due to the higher performance of industrial devices and global environmental issues. The heat generated from semiconductor elements mounted in such power modules also continues to increase. Therefore, heat dissipation is important for circuit boards for power modules. Ceramic-metal bonded circuit boards in which a metal plate of copper, aluminum, or the like is bonded to a ceramic substrate having high thermal conductivity are widely used. Also, active metal bonding that utilizes a brazing material is widely used as a method to bond the ceramic substrate and the copper plate. Brazing materials used in active metal bonding are called active metal brazing materials.

For example, Japanese Patent No. 6158144 (Patent Literature 1) discusses a ceramic circuit board using a brazing material layer including Ag, Cu, and Ti. In Patent Literature 1, a brazing material layer jutting part is formed at the ceramic circuit board. According to Patent Literature 1, TCT characteristics are improved by forming the brazing material layer jutting part. As in Patent Literature 1, a bonding method that uses a brazing material layer including Ag, Cu, and Ti is called active metal bonding. Generally, in active metal bonding, an active metal is included in the brazing material; and it is common to use Ag, Cu, and Ti as the bonding brazing material. Among the bonding brazing materials, Ag is an expensive element.

For example, JP-A 2003-283064 (Kokai) (Patent Literature 2) discusses the use of a CuSnTi brazing material that does not include Ag. The ceramic circuit board of Patent Literature 2 does not include Ag in the brazing material. Therefore, the etchability of the brazing material layer was good. Patent Literature 2 discusses an active metal brazing material that does not include Ag.

### [Prior Art Documents]

### [Patent Literature]

Patent Literature 1: Japanese Patent No. 6158144
Patent Literature 2: JP-A 2003-283064 (Kokai)

### [Summary of Invention]

### [Problem to be Solved by Invention]

In Patent Literature 2, the etchability of the brazing material layer is improved. On the other hand, a brazing material layer jutting part such as that of Patent Literature 1 could not be formed. Because the brazing material layer jutting part could not be formed, a problem occurred in which the TCT characteristics of the ceramic circuit board degraded.

A ceramic copper circuit board according to an embodiment controls the brazing material layer jutting part of a ceramic copper circuit board that uses a brazing material layer not including Ag.

### [Means for Solving Problem]

A ceramic copper circuit board according to an embodiment includes a ceramic substrate, and a copper circuit part bonded to at least one surface of the ceramic substrate via a brazing material layer. The brazing material layer includes one or two selected from Cu, Ti, Sn, or In. The brazing material layer includes a bonding part located between the ceramic substrate and the copper circuit part, and a first jutting part located at a periphery of the bonding part; and a titanium content of the first jutting part is within a range of not less than 70 mass% and not more than 100 mass%.

### [Brief Description of Drawings]

[FIG. 1]

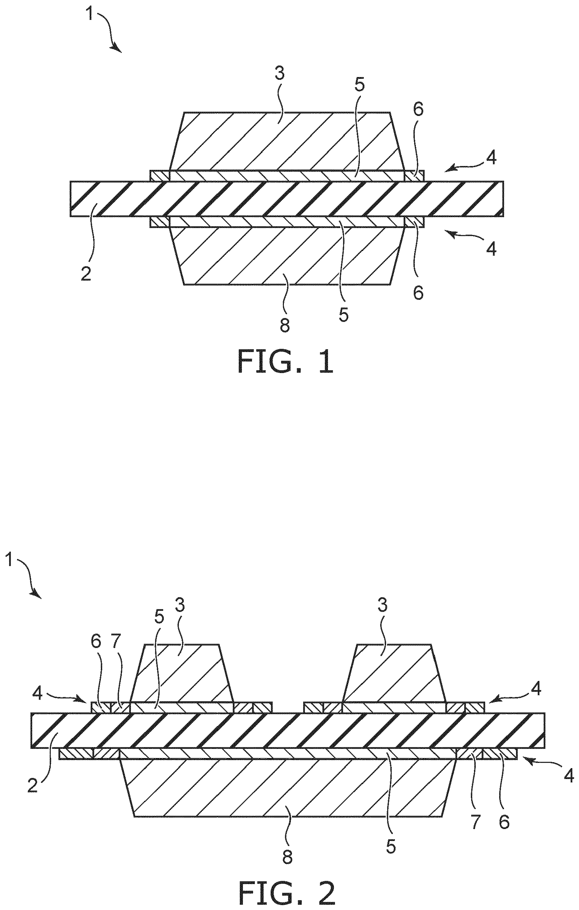

   FIG. 1 is a schematic view showing an example of a ceramic copper circuit board according to an embodiment.
[FIG. 2]
   FIG. 2 is a schematic view showing another example of the ceramic copper circuit board according to the embodiment.
[FIG. 3]

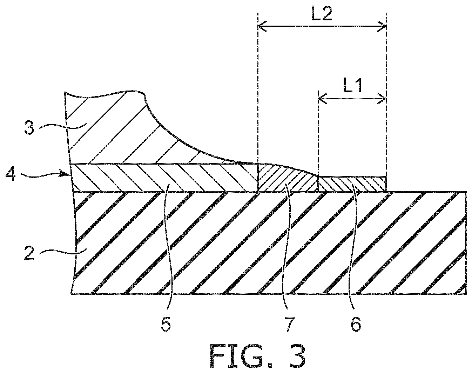

   FIG. 3 is a schematic view showing an example of a jutting part of the ceramic copper circuit board according to the embodiment.
[FIG. 4]

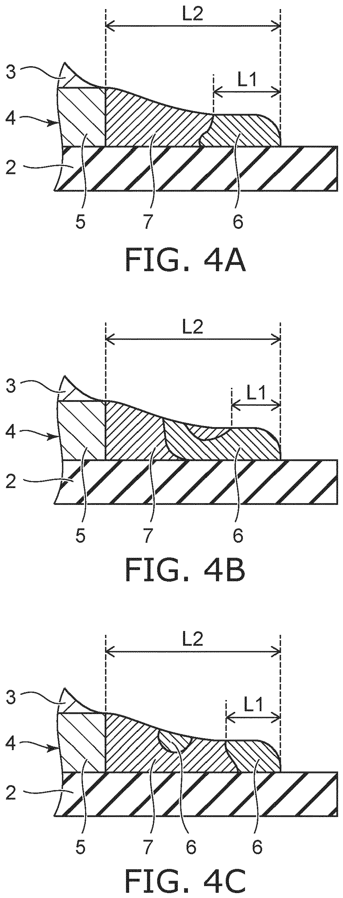

   FIG. 4 is a schematic view showing the length of the first jutting part and the length of the entire jutting part.
[FIG. 5]

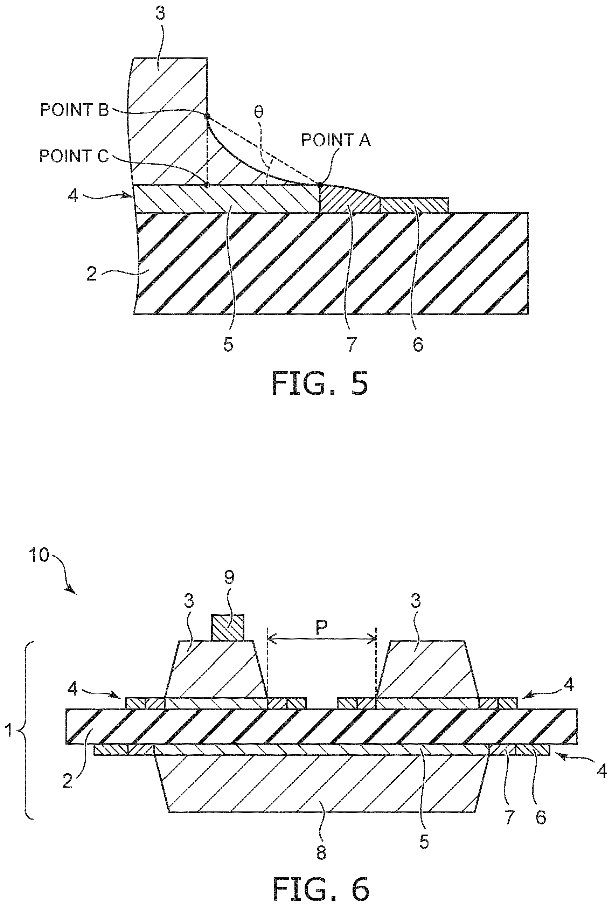

   FIG. 5 is a conceptual view illustrating a method for measuring an inclination angle of a copper circuit part side surface.
[FIG. 6]
   FIG. 6 is a schematic view showing an example of a semiconductor device according to an embodiment.

### [Embodiments of Invention]

A ceramic copper circuit board according to an embodiment includes a ceramic substrate, and a copper circuit part bonded to at least one surface of the ceramic substrate via a brazing material layer. The brazing material layer includes one or two selected from Cu, Ti, Sn, or In. The brazing material layer includes a bonding part located between the ceramic substrate and the copper circuit part, and a first jutting part located at a periphery of the bonding part; and a titanium content of the first jutting part is within a range of not less than 70 mass% and not more than 100 mass%.

FIG. 1 is a schematic view showing an example of a ceramic copper circuit board according to an embodiment. FIG. 2 is a schematic view showing another example of the ceramic copper circuit board according to the embodiment. FIG. 3 is a schematic view showing an example of a jutting part of the ceramic copper circuit board according to the embodiment. In FIGS. 1 to 3, reference numeral 1 is a ceramic copper circuit board; reference numeral 2 is a ceramic substrate; reference numeral 3 is a copper circuit part; reference numeral 4 is a brazing material layer; reference numeral 5 is a bonding part; reference numeral 6 is a first jutting part; reference numeral 7 is a second jutting part; and reference numeral 8 is a copper heat dissipation plate. *L1* is the length of the first jutting part 6; and *L2* is the length of the entire jutting part.

The ceramic copper circuit board 1 according to the embodiment has a structure in which the copper circuit part 3 is bonded to at least one surface of the ceramic substrate 2 via the brazing material layer 4. As shown in FIG. 1, the copper circuit part 3 may be bonded to one surface of the ceramic substrate 2; and the copper heat dissipation plate 8 may be bonded to another surface of the ceramic substrate 2. As shown in FIG. 2, multiple copper circuit parts 3 may be bonded to one surface of the ceramic substrate 2. The copper circuit part 3 may be provided instead of the copper heat dissipation plate 8.

Examples of the ceramic substrate 2 include a silicon nitride substrate, an aluminum nitride substrate, an aluminum oxide substrate, a zirconium oxide substrate, etc. It is favorable for the ceramic substrate 2 to be one of a silicon nitride substrate or an aluminum nitride substrate. The silicon nitride substrate and the aluminum nitride substrate are nitride ceramic substrates. As described below, a titanium nitride layer can be formed at the nitride ceramic substrate by active metal bonding.

The aluminum oxide substrate and the zirconium oxide substrate are oxide ceramic substrates. A titanium oxide layer can be formed at the oxide ceramic substrate by active metal bonding. Comparing the nitride ceramic substrate and the oxide ceramic substrate, the nitride ceramic substrate has a higher thermal conductivity. In this respect, it is favorable to use the nitride ceramic substrate.

It is favorable for the thickness of the ceramic substrate 2 to be not less than 0.1 mm and not more than 3 mm. The strength may be reduced when the substrate thickness is less than 0.1 mm. When the substrate thickness is greater than 3 mm, the ceramic substrate may become a thermal resistor and may degrade the heat dissipation of the bonded body. It is therefore favorable for the thickness of the ceramic substrate 2 to be not less than 0.1 mm and not more than 3 mm, or even not less than 0.2 mm and not more than 1 mm.

It is favorable for the three-point bending strength of the silicon nitride substrate to be not less than 600 MPa. It is favorable for the thermal conductivity of the silicon nitride substrate to be not less than 80 W/m·K. The substrate thickness can be reduced by increasing the strength of the silicon nitride substrate. It is therefore favorable for the three-point bending strength of the silicon nitride substrate to be not less than 600 MPa, or even not less than 700 MPa. The substrate thickness of the silicon nitride substrate can be thin, i.e., not more than 0.40 mm or even not more than 0.30 mm.

The three-point bending strength of the aluminum nitride substrate is about 300 to 450 MPa. On the other hand, the thermal conductivity of the aluminum nitride substrate is not less than 160 W/m K. Because the strength of the aluminum nitride substrate is low, it is favorable for the substrate thickness to be not less than 0.60 mm.

The copper circuit part 3 and the copper heat dissipation plate 8 can include copper plates or copper alloy plates. It is favorable for the copper circuit part 3 and the copper heat dissipation plate 8 to be made of oxygen-free copper. Oxygen-free copper is copper having a copper purity of not less than 99.96 wt% as indicated in JIS-H-3100 (ISO 1337, etc.). By making the copper circuit part 3 and the copper heat dissipation plate 8 thick, the current-carrying capacity and the heat dissipation can be improved. It is therefore favorable for the thicknesses of the copper circuit part 3 and the copper heat dissipation plate 8 to be not less than 0.1 mm, or even not less than 0.6 mm. More favorably, the thicknesses of the copper circuit part 3 and the copper heat dissipation plate 8 are not less than 0.8 mm.

The copper circuit part 3 and the copper heat dissipation plate 8 each are bonded to the ceramic substrate 2 via the brazing material layers 4. The brazing material layer 4 includes the bonding part 5. The bonding part 5 is located between the ceramic substrate 2 and the copper circuit part 3 or between the ceramic substrate 2 and the copper heat dissipation plate 8. The brazing material layer 4 further includes a jutting part located at the periphery of the bonding part 5 in an in-plane direction. The in-plane direction is a direction parallel to the surface of the ceramic substrate 2. The brazing material layer 4 is located at the surface of the ceramic substrate 2. The jutting part juts along the in-plane direction from the edge of the copper circuit part 3 or the copper heat dissipation plate 8.

As shown in FIG. 1, the jutting part includes the first jutting part 6. The titanium content in the first jutting part 6 is within the range of not less than 70 mass% and not more than 100 mass%. It is favorable for the total of the titanium content and the nitrogen content in the first jutting part 6 to be within the range of not less than 90 mass% and not more than 100 mass%.

As shown in FIG. 2, the jutting part may further include the second jutting part 7. The second jutting part 7 is located between the bonding part 5 and the first jutting part 6. The titanium content in the second jutting part 7 is less than 70 mass%. The brazing material layer 4 has a structure in which the bonding part 5, the second jutting part 7, and the first jutting part 6 are connected to each other. The first jutting part 6 is positioned outward of the jutting part. The second jutting part 7 is positioned inward of the jutting part.

The boundary between the bonding part 5 and the jutting part is referenced to the edge of the copper circuit part 3 or the copper heat dissipation plate 8 as shown in FIG. 3. A line perpendicular to the surface of the ceramic substrate 2 is drawn from the edge of the copper circuit part 3 or the copper heat dissipation plate 8. The part that juts from the perpendicular line is the jutting part. The brazing material layer jutting part also is called simply the jutting part.

Scanning electron microscope-energy dispersive X-ray spectrometry (SEM-EDX) is used to measure the titanium content of the jutting part. Area analysis of the jutting part is performed at any cross section of the ceramic copper circuit board 1. In the area analysis, the measurement area is set so that the entire jutting part is the analysis object. The entire jutting part refers to the part of the brazing material layer 4 other than the bonding part 5, and is the entire part jutting from the boundary between the ceramic substrate 2 and the jutting part.

When a copper plate is bonded to a silicon nitride substrate by using a Ti-including brazing material layer, a titanium nitride layer is formed at the surface of the silicon nitride substrate. The boundary between the silicon nitride substrate and the titanium nitride layer is the boundary between the ceramic substrate 2 and the brazing material layer 4. That is, the titanium nitride layer is a portion of the bonding part 5 and a portion of the jutting part. Therefore, in the area analysis, care is taken that the titanium nitride layer is included in the measurement area; and the silicon nitride substrate is not included in the measurement area.

When a copper plate is bonded to an oxide ceramic substrate by using a Ti-including brazing material layer, a titanium oxide layer is formed at the surface of the oxide ceramic substrate. The boundary between the oxide ceramic substrate and the titanium oxide layer is the boundary between the ceramic substrate 2 and the brazing material layer 4. In the area analysis, care is taken that the titanium oxide layer is included in the measurement area; and the oxide ceramic substrate is not included in the measurement area.

Field Emission SEM (FE-SEM) is used in the SEM observation. EDX is also called EDS. JSM-7200F made by JEOL Ltd., or a device having equivalent performance is used in FE-SEM. EX-74600U4L2Q made by JEOL Ltd., or a device having equivalent performance is used in EDX.

The FE-SEM measurement conditions are set to an acceleration voltage of 15 kV, a magnification of 3,000 times, and a field area of 1,200 µm² (= thickness direction 30 µm×width direction 40 µm). The thickness direction is a direction perpendicular to the surface of the ceramic substrate 2. The width direction is a direction parallel to the cross section and the in-plane direction. The EDX measurement conditions are set to 50 scans with a measurement speed of 0.2 ms/bit. When performing the EDX area analysis, 256×198 imaged pixels, a detection count 3,700 to 4,100 cps (Count Per Second), and a quantitative map of 5×5 bit/point are set.

The area analysis also is called surface analysis. In EDX, it is effective to use qualitative analysis using EDX to check the elements included in the brazing material layer beforehand to perform the area analysis after clarifying the elements to be designated.

When measuring the titanium amount of the jutting part of the ceramic copper circuit board 1 using a nitride ceramic substrate, the total of the metal components, silicon, nitrogen, and carbon is set to 100 mass%. When measuring the titanium amount of the jutting part of the ceramic copper circuit board using an oxide ceramic substrate, the total of the metal components, oxygen, and carbon is set to 100 mass%. The metal components are included in the measurement object when the metal components are not less than 0.01 mass%. This is because being less than 0.01 mass% is below the EDX detection limit.

When a silicon nitride substrate is used as the nitride ceramic substrate, silicon and nitrogen diffuse into the brazing material layer. Therefore, silicon and nitrogen are included in the measurement object. Similarly, Al and nitrogen are included in the measurement object for an aluminum nitride substrate. Al and oxygen are included in the measurement object for an aluminum oxide substrate. Zr and oxygen are included in the measurement object for zirconium oxide. Al and Zr are included in the measurement object as types of metal components.

The first jutting part 6 is a region in which the titanium content is not less than 70 mass% and not more than 100 mass%. When a nitride ceramic substrate is used, the tip of the jutting part may include only titanium or titanium nitride. It is favorable for the first jutting part 6 to be a region in which the total of the titanium content and the nitrogen content is not less than 90 mass% and not more than 100 mass%. For the titanium nitride amount of the first jutting part 6, the titanium nitride amount is counted by considering all of the nitrogen detected by EDX to be included in titanium nitride (TiN).

When an oxide ceramic substrate is used, the tip of the jutting part may include only titanium or titanium oxide. It is favorable for the first jutting part 6 to be a region in which the total of the titanium content and the oxygen content is not less than 90 mass% and not more than 100 mass%. For the titanium oxide amount of the first jutting part 6, the titanium oxide amount is counted by considering all of the oxygen detected by EDX to be included in titanium oxide (TiO₂).

An example using a nitride ceramic substrate will now be described. When an oxide ceramic substrate is used, the titanium nitride of the jutting part can be read as titanium oxide.

As described below, the brazing material layer 4 includes one or two selected from Cu (copper), Ti (titanium), Sn (tin), and In (indium). Examples of components of the first jutting part 6 other than titanium and nitrogen include Cu, Sn, and In. When much of these components remained, migration easily occurred between the copper circuit parts 3 adjacent to each other when the distance between the copper circuit parts was reduced.

Migration is a phenomenon in which ionized metal moves between electrodes due to a voltage application when the circuit board is placed in an environment of high humidity, and a short-circuit occurs. The migration due to the ionized metal is called ion migration. In recent years, semiconductor devices have been used in various industrial devices. For example, there are also cases where an electric vehicle is used in an environment of high moisture. In active metal bonding, Ag, Cu, Sn, In, Ti, etc., are used as the bonding brazing material. Among these, Ti has a low ionization tendency, and is resistant to moisture. Ti reacts with the nitride ceramic substrate to form titanium nitride. The formation of titanium nitride can suppress the occurrence of migration. It is therefore necessary for the titanium content of the first jutting part 6 to be within the range of not less than 70 mass% and not more than 100 mass%. Furthermore, it is favorable for the total of the titanium content and the nitrogen content of the first jutting part 6 to be not less than 90 mass% and not more than 100 mass%, or even not less than 99 mass% and not more than 100 mass%.

The titanium content of the second jutting part 7 is less than 70 mass%. In other words, the second jutting part 7 includes not less than 30 mass% of components other than titanium.

As described above, migration is suppressed by increasing the titanium (or titanium nitride) included in the first jutting part 6. On the other hand, when the titanium (or titanium nitride) is increased too much, the stress relaxation effect at the edge vicinity of the copper circuit part 3 or the copper heat dissipation plate 8 is reduced. It is therefore effective for the titanium content of the second jutting part 7 to be less than 70 mass%.

In the second jutting part 7, it is favorable for the Cu content to be not less than 5 mass and not more than 60 mass%, for the content of Sn or In to be not less than 5 mass% and not more than 45 mass%, and for the total content of Ti and titanium nitride to be not less than 10 mass% but less than 90 mass%. The presence of a prescribed amount of one or two selected from Cu, Sn, and In can improve the stress relaxation effect at the edge vicinity of the copper circuit part 3.

The brazing material layer 4 includes one or two selected from Cu, Ti, Sn, and In. It is favorable for the Ag content of the brazing material layer 4 to be not less than 0 mass% and not more than 10 mass%. The brazing material layer 4 may include components other than Cu, Ti, Sn, and In. On the other hand, when the Ag amount in the brazing material layer 4 is high, it may be difficult to form the first jutting part 6. It is therefore favorable for the Ag amount in the brazing material layer 4 to be not more than 10 mass%. More favorably, the Ag amount in the brazing material layer 4 is 0 mass%; and the brazing material layer 4 does not include Ag. The Ag amount being 0 mass% refers to being below the EDX detection limit (less than 0.01 mass%). The brazing material layer 4 may include not more than 10 mass% of metallic elements other than Cu, Ti, Sn, and In. Examples of metallic elements other than Cu, Ti, Sn, and In include one, two, or more selected from carbon, magnesium, molybdenum, tungsten, and rhenium. The brazing material layer 4 may include these elements as long as the total of these elements is not more than 10 mass%.

The Cu content (mass%) of the bonding part 5 is taken as *C1*. The Cu content (mass%) of the second jutting part 7 is taken as *C2*. It is favorable for the mass ratio *C2*/*C1* to be not more than 0.7. This means that the Cu amount at the edge vicinity of the copper circuit part 3 decreases from bonding part 5 -> second jutting part 7 -> first jutting part 6. By providing a gradient in the composition of the Cu amount, the stress relaxation effect can be improved. When the mass ratio *C2*/*C1* is greater than 0.7, the difference between the Cu amount of the second jutting part 7 and the Cu amount of the first jutting part 6 may become too large, and the stress relaxation effect may decrease.

Although the lower limit of the mass ratio *C2*/*C1* is not particularly limited, it is favorable for the lower limit to be not less than 0.1. When the mass ratio *C2*/*C1* is less than 0.1, the Cu amount of the second jutting part 7 may be too low, and the stress relaxation effect may decrease. It is therefore favorable for the mass ratio *C2*/*C1* to be not less than 0.1 and not more than 0.7, or even not less than 0.2 and not more than 0.5.

The area analysis of SEM-EDX described above is used to measure the Cu amount of the bonding part 5, the Cu amount of the first jutting part 6, and the Cu amount of the second jutting part 7. First, the brazing material layer 4 is divided into the bonding part 5 and the jutting part according to the position of the edge of the copper circuit part 3 or the copper heat dissipation plate 8. Then, the jutting part is divided into the region of the first jutting part 6 and the region of the second jutting part 7 according to the Ti amount. The average value of the Cu amount of the bonding part 5 is used as the Cu amount of the bonding part 5. The average value of the Cu amount in the region of the first jutting part 6 is used as the Cu amount of the first jutting part 6. The average value of the Cu amount in the region of the second jutting part is used as the Cu amount of the second jutting part 7.

For the Cu amounts of the bonding part 5, the first jutting part 6, and the second jutting part 7, five measurement areas are analyzed with EDX; and the Cu amounts of the bonding part 5, the first jutting part 6, and the second jutting part 7 included in each measurement area are measured. For each of the bonding part 5, the first jutting part 6, and the second jutting part 7, the average value of the Cu amounts of the five measurement areas are calculated, and the obtained average values are used respectively as the Cu amounts of the parts. The five measurement areas are obtained from five mutually-different cross sections. Multiple cross sections that pass respectively through multiple sides of the copper circuit part 3 of the ceramic copper circuit board 1 may be obtained, or multiple cross sections may be obtained from one side.

The Ti content (mass%) of the bonding part 5 is taken as *C3*. The Ti content (mass%) of the second jutting part 7 is taken as *C4.* It is favorable for the mass ratio *C4*/*C3* to be not more than 1.2. By setting the mass ratio *C4*/*C3* to be not more than 1.2, a gradient can be provided to the composition of the Ti amount from the bonding part 5 toward the second jutting part 7. The mass ratio *C4*/*C3* being greater than 1.2 means that there is less Cu, Sn, etc., in the second jutting part 7. Although not particularly limited, it is favorable for the lower limit of the mass ratio *C4*/*C3* to be greater than 1. It is therefore favorable for the mass ratio *C4*/*C3* to be greater than 1 and not more than 1.2.

The SEM-EDX area analysis described above is used to measure the Ti amounts of the bonding part 5 and the second jutting part 7. The average value of the Ti amount in the region of the second jutting part 7 is used as the Ti amount of the second jutting part 7. The average value of the Ti amount in the region 100 µm inward from the boundary between the bonding part 5 and the jutting part is used as the Ti amount of the bonding part 5.

For the Ti amounts of the bonding part 5 and the second jutting part 7, five measurement areas are analyzed by EDX; and the Ti amounts of the bonding part 5 and the second jutting part 7 included in each measurement area are measured. For each of the bonding part 5 and the second jutting part 7, the average values of the Ti amounts of the five measurement areas are calculated, and the obtained average values are used respectively as the Ti amounts of the parts. The five measurement areas are obtained from five mutually-different cross sections. Multiple cross sections that pass respectively through multiple sides of the copper circuit part of the ceramic copper circuit board may be obtained, or multiple cross sections may be obtained from one side. The five cross sections that are used to measure the Cu amount may be used to measure the Ti amount together with the Cu amount.

As shown in FIG. 3, the length of the first jutting part 6 in the direction from the bonding part 5 toward the first jutting part 6 is taken as *L1*. The length of the entire jutting part in this direction is taken as *L2.* In such a case, it is favorable for 0.3 ≤ *L1*/*L2* ≤ 1 to be satisfied. More favorably, 0.5 ≤ *L1*/*L2* ≤ 0.8.

As described above, migration suppression and a stress relaxation effect are obtained by the presence of the first and second jutting parts 6 and 7. Length L2 - length L1 corresponds to the length of the second jutting part 7. The characteristics of the first and second jutting parts 6 and 7 can be further improved by controlling the length of the first jutting part 6 and the length of the second jutting part 7. In particular, Ag migration can be suppressed by not including Ag in the bonding part 5 and the brazing material layer jutting part. An active metal brazing material is used to bond the ceramic substrate 2 and the copper circuit part 3. Generally, the active metal brazing material includes metals such as Ag, Cu, Ti, Sn, In, etc.; however, in the active metal brazing material, Ag is the element most prone to migration. Ag migration can be suppressed by reducing the Ag content or by not including Ag.

The SEM-EDX area analysis described above is utilized to measure the length (*L1*) of the first jutting part 6 and the length (*L2* - *L1*) of the second jutting part 7. Specifically, the region of the jutting part upper surface in which the titanium content is not less than 70 mass% is designated based on the result of the area analysis. The region of the designated region that is continuous with the jutting part tip is extracted. The jutting part tip is the location most distant to the bonding part 5 at which the ceramic substrate 2 and the first jutting part 6 are in contact. The location in the extracted region most proximate to the copper circuit part 3 is designated. A line is drawn perpendicular to the surface of the ceramic substrate 2 from the location most proximate to the copper plate. The length from the jutting part tip to the perpendicular line is taken as the length L1 of the first jutting part 6. The length (*L2* - *L1*) of the length L1 of the first jutting part 6 subtracted from the length L2 of the entire jutting part is taken as the length of the second jutting part 7.

For example, when the region of the jutting part upper surface in which the titanium content is not less than 70 mass% is discontinuous, the length L1 of the first jutting part is determined using the region continuous with the jutting part tip.

FIGS. 4A to 4C are schematic views showing lengths of the first jutting part and lengths of the entire jutting part. In FIGS. 4A to 4C, reference numeral 6 is the first jutting part; and reference numeral 7 is the second jutting part.

In the example shown in FIG. 4A, the first jutting part 6 is present at the tip of the jutting part. The region in which the titanium content is not less than 70 mass% is one lump. In such a case, the length L1 is measured by designating the location of the first jutting part 6 at the jutting part upper surface most proximate to the copper circuit part 3.

In the example shown in FIG. 4B, the second jutting part 7 is present between a portion and another portion of the first jutting part 6 at the upper surface of the jutting part. In such a case, the length to the jutting part tip from the boundary between the second jutting part 7 and the portion of the first jutting part 6 continuous with the jutting part tip at the upper surface of the jutting part is used as the length L1.

In the example shown in FIG. 4C, multiple first jutting parts 6 that are separated from each other are present at the upper surface of the jutting part. The second jutting part 7 is present between the first jutting parts 6. In such a case, the length to the jutting part tip from the boundary between the second jutting part 7 and one first jutting part 6 continuous with the jutting part tip at the upper surface of the jutting part is used as the length L1.

The bonding part 5 may include carbon. The bonding part 5 including carbon means that the bonding brazing material includes carbon. The fluidity of the brazing material can be controlled by the bonding brazing material including carbon. As a result, the bonding brazing material paste can be uniformly coated. When the bonding part 5 includes carbon, the first jutting part 6 or the second jutting part 7 also may include carbon.

It is favorable for the carbon content of the bonding part 5 to be within the range of not less than 0.01 mass% and not more than 2 mass%. More favorably, the carbon content of the bonding part 5 is within the range of not less than 0.05 mass% and not more than 1 mass%. It is favorable for the carbon content of the first or second jutting part 6 or 7 also to be not less than 0 mass% and not more than 1 mass%.

It is favorable for an inclination angle θ of the side surface of the copper circuit part 3 to be within the range of not less than 30° and not more than 70°. FIG. 5 is a conceptual view illustrating the method for measuring the inclination angle of the copper circuit part side surface. In FIG. 5, reference numeral 3 is the copper circuit part; reference numeral 6 is the first jutting part; and reference numeral 7 is the second jutting part. Also, a point A is the intersection between the brazing material layer 4 and the edge of the copper circuit part 3. A point B is the midpoint of the side surface of the copper circuit part 3 in the thickness direction. A point C is the intersection between the horizontal line from the point A and the perpendicular line from the point B.

A SEM photograph of any cross section of the ceramic copper circuit board 1 is used to measure the inclination angle θ. A SEM photograph from when the jutting part was analyzed by SEM-EDX may be used.

First, the point A, which is the intersection between the brazing material layer 4 and the edge of the copper circuit part 3, and the point B, which is the midpoint of the side surface of the copper circuit part 3 in the thickness direction, are set in the cross-sectional photograph. Then, the point C, which is the intersection of the horizontal line from the point A and the perpendicular line from the point B, is set. A right triangle bounded by the three points ABC is generated. The angle between side BC and side AB is used as the inclination angle θ of the side surface of the copper circuit part 3. The inclination angle θ of the side surface of the copper circuit part 3 also may be called simply the inclination angle θ.

The stress at the bonding end portion can be relaxed by setting the inclination angle θ to be within the range of not less than 30° and not more than 70°. When the inclination angle is less than 30°, the inclined surface of the copper circuit part 3 may lengthen, and the area for mounting the semiconductor element may be reduced. Also, when the inclination angle θ is greater than 70°, the stress relaxation effect of the bonding end portion may be insufficient. It is therefore favorable for the inclination angle θ to be within the range of not less than 30° and not more than 70°, or even not less than 40° and not more than 60°.

The multiple copper circuit parts 3 may be bonded to at least one surface of the ceramic substrate 2. The shortest distance between the adjacent copper circuit parts 3 may be within the range of not less than 0.2 mm and not more than 2 mm.

FIG. 6 is a schematic view showing an example of a semiconductor device according to an embodiment. In FIG. 6, reference numeral 9 is a semiconductor element; and reference numeral 10 is a semiconductor device. Otherwise, the reference numerals are the same as the reference numerals of FIG. 1. *P* is the shortest distance between the adjacent copper circuit parts 3. The shortest distance between the adjacent copper circuit parts 3 also is called the pitch. When an inclined surface is provided in the copper circuit part 3, the shortest distance between the side surface edges of the copper circuit part 3 is the pitch P. In other words, the distance between the intersection between the brazing material layer jutting part and the edge of the copper circuit part 3 is the pitch P.

The pitch P being within the range of not less than 0.2 mm and not more than 2 mm means that the distance between the adjacent copper circuit parts 3 is short. For the same size of the ceramic substrate, the bonding area of the copper circuit part 3 can be increased by reducing the distance between the adjacent copper circuit parts 3. That is, the mounting area of the semiconductor element 9, etc., can be increased. Also, for the same size of the copper circuit part 3, the size of the ceramic copper circuit board 1 can be reduced. That is, the ceramic copper circuit board 1 can be smaller without reducing the mounting area of the semiconductor element 9, etc. In the ceramic copper circuit board 1 according to the embodiment, the pitch P may not be within the range of not less than 0.2 mm and not more than 2 mm. On the other hand, the effects described above can be obtained when the pitch P is within the range of not less than 0.2 mm and not more than 2 mm. Also, when three or more copper circuit parts 3 are bonded, it is favorable for the pitch P to be within the range of not less than 0.2 mm and not more than 2 mm at not less than two locations. For example, the shortest distance between one copper circuit part 3 and another copper circuit part 3 adjacent to the one copper circuit part 3 is within the range of not less than 0.2 mm and not more than 2 mm. Also, the shortest distance between the other copper circuit part 3 and yet another copper circuit part 3 adjacent to the other copper circuit part 3 is within the range of not less than 0.2 mm and not more than 2 mm.

It is favorable for 1 ≤ *P*/*D* ≤ 3 to be satisfied, wherein *D* is the thickness of the copper plate. There are also cases where migration occurs at the side surface of the copper circuit part 3 in addition to the tip of the brazing material layer jutting part. It is therefore favorable to set the pitch P according to the thickness D of the copper circuit part 3.

Such a ceramic copper circuit board 1 is applicable to the semiconductor device 10 to which the semiconductor element 9 is mounted. As shown in FIG. 6, the semiconductor element 9 is mounted on the copper circuit part 3. In the example shown in FIG. 6, one semiconductor element 9 is mounted. Multiple semiconductor elements 9 may be mounted respectively to multiple copper circuit parts 3. A leadframe or wire bonding may be included as necessary. Also, a plating film, a mold resin, etc., may be provided at the surface of the copper circuit part 3 as necessary.

According to the ceramic copper circuit board 1 according to the embodiment, the occurrence of migration can be suppressed. Furthermore, the occurrence of migration can be further suppressed by the pitch P being within the range of not less than 0.2 mm and not more than 2 mm, or by 1 ≤ *P*/*D* ≤ 3 being satisfied.

A method for manufacturing the ceramic copper circuit board 1 according to the embodiment will now be described. The manufacturing method is not limited as long as the ceramic copper circuit board 1 according to the embodiment has the configuration described above. The following method is illustrated as an example to obtain the ceramic copper circuit board 1 with a high yield.

First, the ceramic substrate 2 is prepared. Examples of the ceramic substrate 2 include a silicon nitride substrate, an aluminum nitride substrate, etc. A copper plate or a copper alloy plate can be used as the member for forming the copper circuit part 3 or the copper heat dissipation plate 8. It is favorable for the copper plate to be oxygen-free copper. Oxygen-free copper is copper that has a copper purity of not less than 99.96 wt% as indicated in JIS-H-3100. JIS-H-3100 (2018) corresponds to ISO 1337, etc.

Then, a bonding brazing material is prepared. It is favorable for the bonding brazing material to include not less than 50 mass% of Cu, not less than 4 mass% and not more than 30 mass% of Ti, not less than 5 mass% and not more than 45 mass% of one or two selected from Sn or In, and not less than 0 mass% and not more than 2 mass% of carbon. Ti may be added as titanium hydride (TiH₂). It is effective not to add Ag to the bonding brazing material. A bonding brazing material to which the active metal, Ti (including TiH₂), is added is an active metal brazing material. Also, when a thermal bonding process is performed using a continuous furnace as described below, the Ti amount is favorably not less than 2 mass%, and more favorably not less than 5 mass%. The thermal bonding process is performed in a nitrogen atmosphere in the continuous furnace. When the Ti amount in the active metal brazing material is increased, the Ti that contributes to the bonding can be ensured even when the Ti reacts with the nitrogen atmosphere.

It is favorable for the average particle size D₅₀ of the Cu powder used as the raw material of the brazing material to be not more than 12.0 µm, or even not more than 10.0 µm. It is favorable for the average particle size D₅₀ of the Ti powder or the TiH₂ powder to be not more than 6.0 µm, or even not more than 4.0 µm. It is favorable for the average particle size D₅₀ of the Sn powder or the In powder to be not more than 16.0 µm, or even not more than 14.0 µm. It is favorable for the average particle size D₅₀ of the carbon powder to be not more than 6.0 µm, or even not more than 4.0 µm. The reactions of the powders can be made uniform by controlling the particle sizes of the powders. Although Ag may be added to the raw material in a small amount, it is favorable not to add Ag.

It is favorable for the average particle size D₅₀ of the Cu powder to be less than the average particle size D₅₀ of the Sn powder or the In powder. As described above, one or two selected from Cu, Sn, and In is used as the base material of the brazing material composition. The melting point of Sn or In is less than the melting point of Cu. The reaction of the Cu powder with the Sn or In powder can be made homogeneous by controlling the Sn or In particle size.

When a metallic element other than Cu, Ti, Sn, and In is added to the brazing material as well, it is favorable for the average particle size D₅₀ of the metallic element powder to be less than the average particle size D₅₀ of the Sn powder or the In powder. Examples of the metallic element other than Cu, Ti, Sn, and In include one, two, or more selected from carbon, magnesium, molybdenum, tungsten, rhenium, and cobalt. These elements may be added to the raw material as long as the total of these elements is not more than 10 mass%.

A process of bonding the ceramic substrate 2 and the copper plate is performed using such a bonding brazing material. A brazing material paste is prepared by mixing the bonding brazing material with an organic substance. A brazing material paste layer is formed by coating the brazing material paste on the surface of the ceramic substrate 2 (or the copper plate). The copper plate (or the ceramic substrate 2) is placed on the brazing material paste layer. The stack of the ceramic substrate, the brazing material paste, and the copper plate is called an unbonded stacked body.

Either a batch technique or a continuous technique may be used in the thermal bonding process. The batch technique is a technique in which the unbonded stacked body is placed in a storage container, and heat treatment is performed. The continuous technique is a technique in which the unbonded stacked body is placed on a belt conveyor, and heat treatment is performed while being moved. The batch technique is suited to a bonding process in a vacuum. The continuous technique is suited to a bonding process in a nitrogen atmosphere. A batch thermal bonding device also is called a batch furnace. A continuous thermal bonding device also is called a continuous furnace.

In the batch technique, it is favorable for the heating temperature to be not less than 750 °C and not more than 850 °C, and the pressure to be a vacuum of not more than 10⁻³ Pa. In the continuous technique, it is favorable for the heating temperature to be within the range of not less than 750 °C and not more than 950 °C.

In the continuous technique, the thermal bonding process is performed in a nitrogen atmosphere. The nitrogen atmosphere is an atmosphere in which nitrogen is not less than 70 vol%. It is favorable for the nitrogen amount of the nitrogen atmosphere to be not less than 70 vol%, or even not less than 85 vol% and not more than 100 vol%. Other than nitrogen gas, examples of the nitrogen atmosphere include an inert gas or ambient air. When the thermal bonding process is performed in the nitrogen atmosphere, the thermal bonding process can be performed using various conditions such as atmospheric pressure, reduced pressure, pressurized, etc.

The thermal bonding process includes a temperature raising process, a holding process, and a temperature lowering process. In the temperature raising process, for example, the temperature rises from room temperature to the bonding temperature. The holding process is performed after the temperature raising process; and the bonding temperature is maintained. The temperature lowering process is performed after the holding process; and the temperature falls from the bonding temperature to, for example, room temperature.

In the temperature raising process of the continuous technique, the temperature raising rate is set to be not less than 30 °C/min. Although not particularly limited, it is favorable for the upper limit of the temperature raising rate to be not more than 100 °C/min. When the temperature raising rate is greater than 100 °C/min, there is a possibility that the bondability may degrade. It is therefore favorable for the temperature raising rate to be not less than 30 °C/min and not more than 100 °C/min, or even not less than 40 °C/min and not more than 70 °C/min.

It is favorable for the bonding temperature to be not less than 750 °C. It is favorable for the upper limit of the bonding temperature to be not more than 1,000 °C. When the bonding temperature is greater than 1,000 °C, the bonding temperature approaches the melting point of copper (1,085 °C); and there is a possibility that the copper plate may deform. It is therefore favorable for the bonding temperature to be not less than 750 °C and not more than 1,000 °C, or even not less than 800 °C and not more than 950 °C.

In the holding process, the bonding temperature is maintained for not less than 10 minutes. The holding time of the bonding temperature is called the heating holding time. It is favorable for the heating holding time to be not less than 10 minutes and not more than 100 minutes. When the heating holding time is less than 10 minutes, there is a possibility that the time may be insufficient for the brazing material to melt or solidify. When the heating holding time is greater than 100 minutes, there is a possibility that too much Sn or In may diffuse into the copper plate.

In the temperature lowering process after the holding process, the temperature lowering rate is set to be not less than 30 °C/min. Although not particularly limited, it is favorable for the upper limit of the temperature lowering rate to be not more than 100 °C/min. When the temperature lowering rate is greater than 100 °C/min, there is a possibility that the bondability may degrade. It is therefore favorable for the temperature lowering rate to be not less than 30 °C/min and not more than 100 °C/min, or even not less than 40 °C/min and not more than 70 °C/min.

It is favorable for the difference between the temperature raising rate and the temperature lowering rate to be not more than 20 °C/min. That is, it is favorable for |temperature raising rate - temperature lowering rate| ≤ 20 °C/min to be satisfied. A melting reaction and a solidification reaction are caused by heating the brazing material paste. These reactions occur in the temperature raising process and the temperature lowering process. The stress that occurs in the melting reaction and the solidification reaction can be homogenized by reducing the difference between the temperature raising rate and the temperature lowering rate. Discrepancies such as warp, etc., can be suppressed thereby. The thermal bonding process may be performed with a weight placed on the bonded body as necessary.

An unbonded stacked body on which the thermal bonding process has been performed is called a bonded body. A pattern shape is provided in the copper plate by patterning by etching the obtained bonded body. The copper circuit part 3 is formed by providing the pattern shape in the copper plate. The ceramic copper circuit board 1 that includes the copper circuit part 3 is obtained. Multi-part manufacturing may be performed by scribing as necessary. Multi-part manufacturing is a method in which small bonded bodies are obtained by cutting a large bonded body. There is also a method of subdividing the bonded body or a method of subdividing the ceramic copper circuit board.

In the etching process, the copper circuit part 3 and the copper heat dissipation plate 8 are formed by etching the copper plate. A portion of the brazing material layer 4 is exposed by etching the copper plate. Then, a process of etching the brazing material layer 4 is performed. It is favorable for the process of etching the brazing material layer to be performed not less than two times. A chemical polishing process may be combined with the etching of the brazing material layer as necessary. The processing time can be shortened by combining chemical polishing with the etching of the brazing material layer.

By performing the process of etching the brazing material layer 4 not less than two times, the titanium contents of the first and second jutting parts 6 and 7 can be controlled. Also, the length L1 of the first jutting part 6 and the length L2 of the entire jutting part can be controlled by adjusting the concentration of the etchant, the processing time of the etchant, etc.

The titanium amount of the first jutting part 6, the length L1 of the first jutting part 6, etc., can be adjusted by using a resist. The resist is located, after the copper plate is etched, on the location of the jutting part at which the second jutting part is formed. Also, for example, when the process of etching the brazing material layer 4 is performed multiple times, there is a method in which the etching durations of the second and subsequent times are less than the etching duration of the first time. A method in which the side surface of the copper circuit part 3 is etched after the brazing material layer 4 is etched also is effective. The second jutting part 7 can be formed by etching the side surface of the copper circuit part 3. The first jutting part 6 may be provided by further etching the second jutting part 7 as necessary. By etching the second jutting part 7, the elements (e.g., copper) other than titanium included in the second jutting part 7 are removed; and the first jutting part 6 is formed.

The etchant for etching the side surface of the copper circuit part 3 can include an iron(III) chloride solution. A chemical polishing liquid may be used instead of the iron(III) chloride solution. It is favorable to use a chemical polishing liquid in which sulfuric acid and hydrogen peroxide are mixed as the chemical polishing liquid. An etching mask (a resist) is coated onto the surface of the copper circuit part 3 as necessary.

The etching process of the brazing material layer 4 and an etching process for providing an incline in the side surface of the copper circuit part 3 may be combined. As described above, the brazing material layer 4 is easily etched in the etching process of the copper circuit part 3 by not including Ag in the brazing material layer 4.

A semiconductor device is obtained by mounting a semiconductor element, etc., to the obtained ceramic copper circuit board.

### (Examples)

### (Examples 1 to 6 and comparative examples 1 to 2)

The ceramic substrates 2 shown in Table 1 and the copper plates shown in Table 2 were prepared. Oxygen-free copper plates were used for each of the copper plates.

**[Table 1]**

| Ceramic substrate | Thermal conductivity (W/m·K) | Three-point bending strength (MPa) | Size (length×width ×thickness mm) |
|---|---|---|---|
| Silicon nitride substrate 1 | 90 | 650 | 200×100×0.32 |
| Silicon nitride substrate 2 | 80 | 700 | 200×150×0.25 |
| Aluminium nitride substrate 1 | 180 | 370 | 100×100×0.635 |

**[Table 2]**

| Copper plate | Size (length×width×thickness mm) |
|---|---|
| Copper plate 1 | 195×95×0.8 |
| Copper plate 2 | 195×145×0.6 |
| Copper plate 3 | 95×95×0.3 |

Then, the bonding brazing materials shown in Table 3 were prepared.

**[Table 3]**

| | Composition ratio (mass%) | | | | |
|---|---|---|---|---|---|
| | Cu powder | Sn powder | TiH₂ powder | C powder | Ag powder |
| Brazing material 1 | 60 | 30 | 10 | - | - |
| Brazing material 2 | 69.8 | 24 | 6 | 0.2 | - |
| Brazing material 3 | 72.7 | 15 | 12 | 0.3 | - |
| Brazing material 4 | 53.9 | 33 | 13 | 0.1 | - |
| Brazing material 5 | 42 | 5 | 3 | - | 50 |

Bonding brazing material pastes were prepared using the bonding brazing materials; and the unbonded stacked bodies shown in Table 4 were made. Copper plates were placed at the two surfaces of the ceramic substrate 2.

**[Table 4]**

| | Ceramic substrate | Copper plate | Brazing material |
|---|---|---|---|
| Unbonded stacked body 1 | Silicon nitride substrate 1 | Copper plate 1 | Brazing material 1 |
| Unbonded stacked body 2 | Silicon nitride substrate 1 | Copper plate 1 | Brazing material 2 |
| Unbonded stacked body 3 | Silicon nitride substrate 1 | Copper plate 3 | Brazing material 3 |
| Unbonded stacked body 4 | Silicon nitride substrate 2 | Copper plate 1 | Brazing material 3 |
| Unbonded stacked body 5 | Silicon nitride substrate 2 | Copper plate 2 | Brazing material 4 |
| Unbonded stacked body 6 | Aluminium nitride substrate 1 | Copper plate 3 | Brazing material 3 |
| Unbonded stacked body 7 | Silicon nitride substrate 2 | Copper plate 2 | Brazing material 5 |

Then, bonded bodies were made by performing a thermal bonding process on the unbonded stacked bodies. A continuous furnace was used in the thermal bonding process. The heating holding temperature was set to be not less than 850 °C and not more than 950 °C; and the heating holding time was set to be not less than 30 minutes and not more than 60 minutes. The temperature raising rate and the temperature lowering rate were set to 20 to 100 °C/min. The difference between the temperature raising rate and the temperature lowering rate was set to be not more than 20 °C/min. The thermal bonding process was performed in a nitrogen atmosphere. Bonded bodies were obtained by the thermal bonding process. Bonded bodies 1 to 7 were obtained respectively from unbonded stacked bodies 1 to 7.

Ceramic copper circuit boards according to the examples and the comparative examples were made by performing an etching process on the obtained bonded bodies. The configurations of the bonded bodies were as shown in Table 5. The methods for measuring the titanium amount, the total amount of titanium and nitrogen, the length L1, the length L2, and the inclination angle θ were as described above.

**[Table 5]**

| | Bonded body | Length L2 (µm) | First jutting part | | | Second jutting part | | inclination angle θ(°) |
|---|---|---|---|---|---|---|---|---|
| | | | Ti amount (mass%) | Total amount of Ti and N (mass%) | Length L1 (µm) | Ti amount (mass%) | L2-L1 (µm) | |
| Example 1 | Bonded body 1 | 85 | 73.6 | 95 | 50 | 53.2 | 35 | 30 |
| Example 2 | Bonded body 2 | 60 | 76.8 | 99 | 40 | 57.8 | 20 | 40 |
| Example 3 | Bonded body 3 | 90 | 77.8 | 99 | 60 | 38.2 | 30 | 50 |
| Example 4 | Bonded body 4 | 45 | 77.3 | 100 | 30 | 30.1 | 15 | 50 |
| Example 5 | Bonded body 5 | 50 | 77.3 | 100 | 30 | 34.7 | 20 | 70 |
| Example 6 | Bonded body 6 | 75 | 77.8 | 99 | 45 | 54.1 | 30 | 30 |
| Comparative example 1 | Bonded body 7 | 100 | - | - | - | 19.8 | 100 | 50 |
| Comparative example 2 | Bonded body 5 | 100 | - | - | - | 45 | 100 | 50 |

It can be seen from Table 5 that the ceramic copper circuit boards according to the examples included the first jutting part 6 and the second jutting part 7. In the second jutting part 7, Cu was within the range of not less than 5 mass and not more than 60 mass%; and Sn was within the range of not less than 5 mass% and not more than 45 mass%. In contrast, the ceramic copper circuit boards according to the comparative examples did not include the first jutting part 6. In the comparative examples, only the jutting part in which the titanium content was less than 70 mass% was present. In the ceramic copper circuit boards according to the examples, the titanium amount of the first jutting part 6 was not less than 70 mass%; and the titanium amount of the second jutting part 7 was less than 70 mass%.

Also, the Cu amount C1 (mass%) of the bonding part 5 and the Cu amount C2 (mass%) of the second jutting part 7 were compared. The Ti amount C3 (mass%) of the bonding part 5 and the Ti amount C4 (mass%) of the second jutting part 7 were compared. The Ti amount (mass%) was the amount (mass%) of the total of titanium and titanium nitride. Also, the shortest distance (the pitch) P between the adjacent copper circuit parts 3 and pitch P/copper circuit part thickness D were measured. The results are shown in Table 6.

**[Table 6]**

| | C2/C1 | C4/C3 | Shortest distance P (mm) | P/D |
|---|---|---|---|---|
| Example 1 | 0.7 | 1.2 | 1.8 | 2.3 |
| Example 2 | 0.5 | 1.1 | 1.5 | 1.9 |
| Example 3 | 0.4 | 1.1 | 0.5 | 1.7 |
| Example 4 | 0.3 | 1.1 | 1.4 | 1.8 |
| Example 5 | 0.5 | 1.0 | 1.2 | 2.0 |
| Example 6 | 0.2 | 1.2 | 0.5 | 1.7 |
| Comparative example 1 | 0.9 | 1.4 | 1.2 | 2.0 |
| Comparative example 2 | 0.9 | 1.4 | 1.2 | 2.0 |

A heat resistance cycle test (TCT test) and a migration test were performed for the ceramic copper circuit boards according to the examples and the comparative examples.

In the TCT test, one cycle was -50 °C×30 minutes -> 25 °C×10 minutes -> 155 °C×30 minutes -> 25 °C×10 minutes. For the silicon nitride substrates, the presence or absence of discrepancies after 2,000 cycles was checked. For the aluminum nitride substrates, the presence or absence of discrepancies after 500 cycles was checked. A discrepancy is the occurrence of a crack in the brazing material layer or the ceramic substrate. The presence or absence of discrepancies was checked using ultrasonic testing. The tests were performed for one hundred ceramic copper circuit boards for each example and comparative example; and the occurrence rates (%) of the discrepancy were checked.

In the migration test, the measurement environment was set to 85 °C and a humidity of 85%; and the ceramic copper circuit board was left for 2,000 hours with a DC voltage of 1,000 V applied between the front and back surfaces of the ceramic copper circuit board in which a pattern was formed. After this time, the ceramic copper circuit board was dried at 120 °C×2 hours, and then the insulation resistance value between the copper circuit part 3 at the front side and the copper heat dissipation plate 8 at the backside and the insulation resistance value between the adjacent copper circuit parts 3 at the front side were measured.

Bonded bodies for which the change rate of the insulation resistance values before and after the test was not more than 10% were taken to be good. Bonded bodies for which the change rate was not less than 11% were taken to be defective. The determination was performed by change rate (%) = [(insulation resistance value after testing - insulation resistance value before testing)/insulation resistance value before testing]×100. The tests were performed, and the defect occurrence rate (%) was checked for each set of one hundred ceramic copper circuit boards. In the migration test, the insulation resistance value between the copper circuit part 3 at the front side and the copper heat dissipation plate 8 at the backside was measured for fifty ceramic copper circuit boards; and the insulation resistance value between the adjacent copper circuit parts 3 at the front side was measured for the other fifty ceramic copper circuit boards. When measuring the insulation resistance value between the adjacent copper circuit parts 3 at the front side, wire bonding or copper tape between copper circuit patterns at the front side was provided as necessary to prepare the copper circuit patterns to have the same potential.

The results are shown in Table 7.

**[Table 7]**

| | TCT test discrepancy occurrence rate(%) | Migration test defect occurrence rate(%) |
|---|---|---|
| Example 1 | 0 | 0 |
| Example 2 | 0 | 0 |
| Example 3 | 0 | 0 |
| Example 4 | 0 | 0 |
| Example 5 | 0 | 0 |
| Example 6 | 0 | 0 |
| Comparative example 1 | 0 | 18 |
| Comparative example 2 | 0 | 5 |

It can be seen from Table 7 that good TCT characteristics were obtained for the ceramic copper circuit boards according to the examples. Good results also were obtained for the migration test.

The TCT characteristics of the ceramic copper circuit boards according to the comparative examples 1 and 2 were equivalent to the TCT characteristics of the ceramic copper circuit boards according to the examples. However, the migration characteristics of the ceramic copper circuit boards according to the comparative examples 1 and 2 degraded compared to the migration characteristics of the ceramic copper circuit boards according to the examples. Therefore, it can be seen that the inclusion of the first and second jutting parts was effective to further improve the migration characteristics while improving the TCT characteristics.

Embodiments may include the following features.

### Feature 1

A ceramic copper circuit board, comprising:
a ceramic substrate; and
a copper circuit part bonded to at least one surface of the ceramic substrate via a brazing material layer,
the brazing material layer including one or two selected from Cu, Ti, Sn, or In,
the brazing material layer including
   a bonding part located between the ceramic substrate and the copper circuit part, and
   a first jutting part located at a periphery of the bonding part, a titanium content of the first jutting part being within a range of not less than 70 mass% and not more than 100 mass%.

### Feature 2

The ceramic copper circuit board according to Feature 1, wherein
the brazing material layer further includes a second jutting part located between the bonding part and the first jutting part, and
a titanium content of the second jutting part is less than 70 mass%.

### Feature 3

The ceramic copper circuit board according to Feature 2, wherein
the second jutting part includes Cu at not less than 5 mass% and not more than 60 mass%, and Sn or In at not less than 5 mass% and not more than 45 mass%, and
a total of the titanium content and a nitrogen content of the second jutting part is within a range of not less than 10 mass% but less than 90 mass%.

### Feature 4

The ceramic copper circuit board according to any one of Features 2 to 3, wherein
a mass ratio of a Cu content of the second jutting part to a Cu content of the bonding part is not more than 0.7.

### Feature 5

The ceramic copper circuit board according to any one of Features 1 to 4, wherein
a total of the titanium content and a nitrogen content of the first jutting part is within a range of not less than 90 mass% and not more than 100 mass%.

### Feature 6

The ceramic copper circuit board according to any one of Features 1 to 5, wherein
a total of the titanium content and a nitrogen content of the first jutting part is within a range of not less than 99 mass% and not more than 100 mass%.

### Feature 7

The ceramic copper circuit board according to any one of Features 1 to 6, wherein
0.3 ≤ *L1*/*L2* ≤ 1 is satisfied,
*L1* is a length of the first jutting part in a direction from the bonding part toward the first jutting part, and
*L2* is a length in the direction of a part of the brazing material layer other than the bonding part.

### Feature 8

The ceramic copper circuit board according to any one of Features 1 to 7, wherein
the brazing material layer further includes carbon.

### Feature 9

The ceramic copper circuit board according to any one of Features 1 to 8, wherein
the brazing material layer does not include Ag.

### Feature 10

The ceramic copper circuit board according to any one of Features 1 to 9, wherein
an inclination angle of a side surface of the copper circuit part is within a range of not less than 30 degrees and not more than 70 degrees.

### Feature 11

The ceramic copper circuit board according to any one of Features 1 to 10, wherein
a plurality of the copper circuit parts is bonded to the at least one surface,
the plurality of copper circuit parts is adjacent to each other, and
a shortest distance between the plurality of copper circuit parts is within a range of not less than 0.2 mm and not more than 2 mm.

### Feature 12

The ceramic copper circuit board according to any one of Features 1 to 11, wherein
the ceramic substrate is a silicon nitride substrate.

### Feature 13

The ceramic copper circuit board according to any one of Features 1 to 12, wherein
a thickness of the copper circuit part is not less than 0.6 mm.

### Feature 14

A semiconductor device, comprising:
the ceramic copper circuit board according to any one of Features 1 to 13; and
a semiconductor element mounted on the copper circuit part.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments described above can be implemented in combination with each other.

### [Reference Numeral List]

1 ceramic copper circuit board
2 ceramic substrate
3 copper plate
4 brazing material layer
5 bonding part
6 first jutting part
7 second jutting part
8 copper heat dissipation plate
9 semiconductor element
10 semiconductor device
L1 length of first jutting part
L2 length of entire jutting part
P shortest distance between adjacent copper plates
θ inclination angle of copper circuit part side surface
point A intersection between copper circuit part edge and brazing material layer
point B midpoint of copper circuit part side surface in thickness direction
point C intersection of horizontal line from point A and perpendicular line from point B

## Claims

1. A ceramic copper circuit board (1), comprising:
a ceramic substrate (2); and
a copper circuit part (3) bonded to at least one surface of the ceramic substrate (2) via a brazing material layer (4),
the brazing material layer (4) including one or two selected from Cu, Ti, Sn, or In,
the brazing material layer (4) including
a bonding part (5) located between the ceramic substrate (2) and the copper circuit part (3), and
a first jutting part (6) located at a periphery of the bonding part (5), a titanium content of the first jutting part (6) being within a range of not less than 70 mass% and not more than 100 mass%.

2. The ceramic copper circuit board (1) according to claim 1, wherein
the brazing material layer (4) further includes a second jutting part (7) located between the bonding part (5) and the first jutting part (6), and
a titanium content of the second jutting part (7) is less than 70 mass%.

3. The ceramic copper circuit board (1) according to claim 2, wherein
the second jutting part (7) includes Cu at not less than 5 mass% and not more than 60 mass%, and Sn or In at not less than 5 mass% and not more than 45 mass%, and
a total of the titanium content and a nitrogen content of the second jutting part (7) is within a range of not less than 10 mass% but less than 90 mass%.

4. The ceramic copper circuit board (1) according to claim 2, wherein
a mass ratio of a Cu content of the second jutting part (7) to a Cu content of the bonding part (5) is not more than 0.7.

5. The ceramic copper circuit board (1) according to claim 1, wherein
a total of the titanium content and a nitrogen content of the first jutting part (6) is within a range of not less than 90 mass% and not more than 100 mass%.

6. The ceramic copper circuit board (1) according to claim 1, wherein
a total of the titanium content and a nitrogen content of the first jutting part (6) is within a range of not less than 99 mass% and not more than 100 mass%.

7. The ceramic copper circuit board (1) according to claim 1, wherein
0.3 ≤ *L1*/*L2* ≤ 1 is satisfied,
*L1* is a length of the first jutting part (6) in a direction from the bonding part (5) toward the first jutting part (6), and
*L2* is a length in the direction of a part of the brazing material layer (4) other than the bonding part (5).

8. The ceramic copper circuit board (1) according to claim 1, wherein
the brazing material layer (4) further includes carbon.

9. The ceramic copper circuit board (1) according to claim 1, wherein
the brazing material layer (4) does not include Ag.

10. The ceramic copper circuit board (1) according to claim 1, wherein
an inclination angle of a side surface of the copper circuit part (3) is within a range of not less than 30 degrees and not more than 70 degrees.

11. The ceramic copper circuit board (1) according to claim 1, wherein
a plurality of the copper circuit parts (3) is bonded to the at least one surface,
the plurality of copper circuit parts (3) is adjacent to each other, and
a shortest distance between the plurality of copper circuit parts (3) is within a range of not less than 0.2 mm and not more than 2 mm.

12. The ceramic copper circuit board (1) according to claim 1, wherein
the ceramic substrate (2) is a silicon nitride substrate.

13. The ceramic copper circuit board (1) according to claim 1, wherein
a thickness of the copper circuit part (3) is not less than 0.6 mm.

14. The ceramic copper circuit board (1) according to claim 2, wherein
the brazing material layer (4) does not include Ag,
the ceramic substrate (2) is a silicon nitride substrate, and
a thickness of the copper circuit part (3) is not less than 0.6 mm.

15. The ceramic copper circuit board (1) according to claim 14, wherein
the brazing material layer (4) further includes carbon.

16. The ceramic copper circuit board (1) according to claim 14, wherein
a plurality of the copper circuit parts (3) is bonded to the at least one surface,
the plurality of copper circuit parts (3) is adjacent to each other, and
a shortest distance between the plurality of copper circuit parts (3) is within a range of not less than 0.2 mm and not more than 2 mm.

17. The ceramic copper circuit board (1) according to claim 15, wherein
a plurality of the copper circuit parts (3) is bonded to the at least one surface,
the plurality of copper circuit parts (3) is adjacent to each other, and
a shortest distance between the plurality of copper circuit parts (3) is within a range of not less than 0.2 mm and not more than 2 mm.

18. A semiconductor device (10), comprising:
the ceramic copper circuit board (1) according to any one of claims 1 to 17; and
a semiconductor element (9) mounted on the copper circuit part (3).
